(19) **Europäisches Patentamt / European Patent Office / Office européen des brevets**

(11) **EP 1 376 659 B1**

(12) **EUROPÄISCHE PATENTSCHRIFT**

(45) Veröffentlichungstag und Bekanntmachung des Hinweises auf die Patenterteilung:
**22.08.2007 Patentblatt 2007/34**

(51) Int Cl.:
*H01L 21/00* *(2006.01)*  *H05K 13/04* *(2006.01)*

(21) Anmeldenummer: **02077647.2**

(22) Anmeldetag: **28.06.2002**

(54) **Klemmelement mit einem integrierten Kraftsensor**

Clamping element with an integrated force sensor

Pince avec un capteur de force intégré

(84) Benannte Vertragsstaaten:
**CH DE LI**

(43) Veröffentlichungstag der Anmeldung:
**02.01.2004 Patentblatt 2004/01**

(73) Patentinhaber: **ESEC Trading SA**
**6330 Cham (CH)**

(72) Erfinder:
• **Onda, Nicolino**
**7310 Bad Ragaz (CH)**
• **Greber, Alexander**
**6205 Eich (CH)**
• **Hess, Peter**
**6318 Walchwil (CH)**

• **Gujer, Hansjörg**
**6312 Steinhausen (CH)**
• **Bernhardsgrueter, Raphael**
**9000 St. Gallen (CH)**

(74) Vertreter: **Falk, Urs**
**Patentanwaltsbüro Dr. Urs Falk**
**Eichholzweg 9A**
**6312 Steinhausen (CH)**

(56) Entgegenhaltungen:
**EP-A- 0 452 041**   **DE-A- 19 523 229**
**US-A- 5 285 946**   **US-A- 5 388 751**
**US-A- 5 704 246**

Printed by Jouve, 75001 PARIS (FR)

**Beschreibung**

Die Erfindung betrifft ein Klemmelement mit einem integrierten Kraftsensor der im Oberbegriff des Anspruchs 1 genannten Art.

Ein solches Klemmelement eignet sich bei der Montage oder Verdrahtung von Halbleiterchips mittels eines in der Fachwelt als Die Bonder bzw. Wire Bonder bekannten Montageautomaten für den Transport von Substraten in einer vorbestimmten Transportrichtung. Eine mit derartigen Klemmelementen arbeitende Transportvorrichtung ist bekannt aus der EP 330 831, während ein solches Klemmelement bekannt ist aus der CH 679 878.

Als Substrate kommen viele verschiedene Materialien zum Einsatz. Einerseits dienen aus einem Blech gestanzte Metallstreifen, sogenannte Leadframes, als Substrate. Solche Leadframes sind in der Regel noch vergleichsweise dick und ziemlich stabil. Andererseits kommen als Substrate auch Folienstreifen aus Kunststoff zum Einsatz, die so dünn sind wie ein Blatt Papier. Die Substrate werden von einem Stapel oder aus einem Magazin entnommen und einer mindestens ein Klemmelement enthaltenden Transportvorrichtung zugeführt, durch welche sie taktweise in der Transportrichtung verschoben und mindestens einer Bearbeitungsstation zugeführt werden. Ein Die Bonder umfasst in der Regel zwei Bearbeitungsstationen, nämlich eine Dispensstation, wo eine Portion Klebstoff auf einen Substratplatz aufgebracht wird, und eine Bondstation, wo ein Halbleiterchip auf dem Substrat platziert wird. Ein Wire Bonder umfasst hingegen nur eine einzige Bearbeitungsstation, wo die Halbleiterchips mit dem Substrat verdrahtet werden. Nach der Bearbeitung werden die Substrate weitertransportiert und in ein Magazin hineingeschoben. Ein solches Magazin ist ein Behälter mit einer Vielzahl übereinander angeordneter Rillen, in deren Zwischenräume die Substrate hineingeschoben werden. Leider kommt es immer wieder vor, dass ein Substrat irgendwo am Magazin anstösst oder hängenbleibt, bevor es seine endgültige Lage im Magazin erreicht hat. Dabei kann das Substrat, insbesondere wenn es relativ dünn ist, beschädigt oder sogar zerstört werden.

Um in einem solchen Fall eine Beschädigung oder Zerstörung des Substrats zu vermeiden, wird bei einigen Montageautomaten eine auf dem Rand des Substrats aufliegende Rolle eingesetzt. Wenn das Substrat in Transportrichtung transportiert wird, dann rollt die Rolle auf dem Substrat ab und liefert ein Signal, dass sie dreht. Sobald das Substrat irgendwo anstösst, ändert sich seine Lage bezüglich der Rolle nicht mehr: Die Rolle steht still. Der Stillstand der Rolle löst ein Signal aus, um die Transportvorrichtung unverzüglich anzuhalten. Diese Detektionsmethode funktioniert bei mechanisch relativ stabilen Substraten ausreichend gut, bei dünnen Foliensteifen aus Kunststoff hingegen nicht.

Eine ebenfalls praktizierte Methode besteht darin, die vom Klemmelement für das Festhalten des Substrats aufgebrachte Klemmkraft so weit wie möglich zu reduzieren, so dass das Klemmelement auf dem Substrat einfach weiterschleift, sobald das Substrat irgendwo anstösst. Das Einstellen des Klemmelementes ist einerseits ein schwieriges Unterfangen. Andererseits ist zudem eine spezielle Ansteuerung des Klemmelementes erforderlich, damit die Klemmbacken zuverlässig öffnen und schliessen. Bei dünnen Folienstreifen ist diese Methode auch nicht mehr verwendbar.

Ein weiteres Klemmelement ist in dem Dokument US 5388751 beschrieben.

Der Erfindung liegt die Aufgabe zugrunde, einen Sensor zu entwickeln, mit dem sich das Anstossen oder Hängenbleiben des Substrates während der Transportphase erkennen und das Anhalten der Transportvorrichtung durchführen lässt, bevor das Substrat beschädigt wird.

Die Erfindung besteht in den im Anspruch 1 angegebenen Merkmalen. Vorteilhafte Ausgestaltungen ergeben sich aus den abhängigen Ansprüchen.

Ein Klemmelement zum Transportieren eines Substrates in einer vorbestimmten Transportrichtung umfasst einen ersten und einen zweiten Schenkel mit einer ersten bzw. zweiten Klemmbacke zum Einklemmen eines Substrats. Jede der beiden Klemmbacken weist eine Klemmplatte auf, die gegenüber dem entsprechenden Schenkel in der Transportrichtung verschiebbar gelagert ist. Ein Sensor misst die Auslenkung der ersten Klemmplatte gegenüber dem ersten Schenkel. Sobald die gemessene Auslenkung einen vorbestimmten Schwellwert überschreitet, wird das Klemmelement geöffnet.

Nachfolgend werden Ausführungsbeispiele der Erfindung anhand der Zeichnung näher erläutert. Die Figuren sind schematisch und nicht massstäblich gezeichnet.

Es zeigen:

Fig. 1  ein Klemmelement mit einem integrierten Kraftsensor,

Fig. 2  das Klemmelement entlang einer Linie I-I der Fig. 1,

Fig. 3  das Klemmelement entlang einer Linie II-II der Fig. 1, und

Fig. 4  den zeitlichen Verlauf eines Steuersignals und des Ausgangssignals des Kraftsensors.

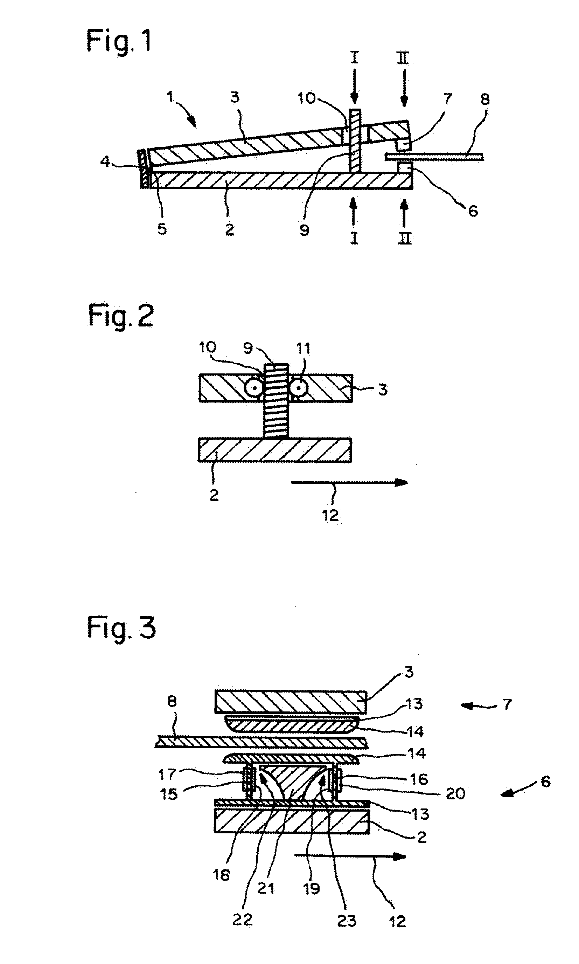

Die Fig. 1 zeigt in seitlicher Ansicht ein Klemmelement 1 mit einem integrierten Kraftsensor. Das Klemmelement 1 umfasst zwei Schenkel 2 und 3, die an ihrem einen Ende durch ein Festkörpergelenk 4 verbunden sind, um eine Drehbewegung des oberen Schenkels 3 um eine senkrecht zur Zeichenebene verlaufende Achse 5 zu ermöglichen. Das andere Ende der beiden Schenkel 2 und 3 umfasst je eine Klemmbacke 6 bzw. 7, die ein Substrat 8 einklemmen. Zum Öffnen und Schliessen des Klemmelementes 1 dient ein vorzugsweise elektromagnetischer Antrieb, der den oberen Schenkel 3 um die Achse 5 dreht. Das Klemmelement 1 umfasst weiter, fakultativ, einen am unteren Schenkel 2 befestigten und am oberen Schenkel 3 gelagerten Bolzen 9. Der Bolzen 9 ragt in eine im oberen Schenkel 3 angebrachte Bohrung 10. Der Bolzen 9 befindet sich in der Nähe der beiden Klemmbacken 6 und 7. Die Fig. 2 zeigt das Klemmelement 1 im Schnitt entlang der Linie I-I der Fig. 1. Am oberen Schenkel 3 sind zwei Kugellager 11 angeordnet für die Lagerung des Bolzens 9.

Das Klemmelement 1 dient zum Transport der Substrate 8 in einer vorgegebenen Transportrichtung 12 (Fig. 2), die parallel zur Achse 5 verläuft. Eine für diesen Zweck geeignete Transportvorrichtung ist z.B. aus der eingangs zitierten EP 330 831 bekannt. Der Bolzen 9 sorgt dafür, dass sich die relative Lage der beiden Schenkel 2 und 3 bezüglich der Transportrichtung 12 beim Beschleunigen und Abbremsen nicht ändert, da eine Änderung der relativen Lage ein Störsignal im Kraftsensor induzieren würde.

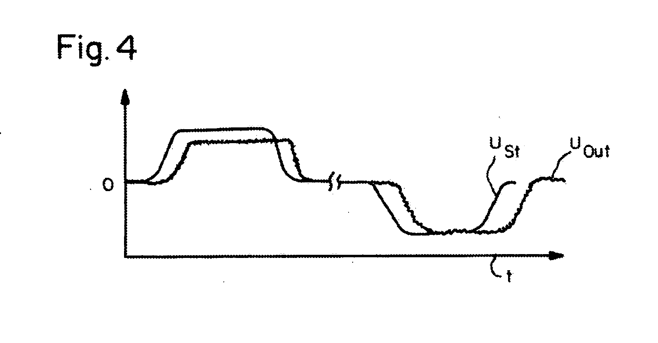

Die Fig. 3 zeigt die Klemmbacken 6 und 7 des Klemmelementes 1 im Schnitt entlang der Linie II-II der Fig. 1. Beide Klemmbacken 6 und 7 umfassen je eine Befestigungsplatte 13 und eine Klemmplatte 14, die parallel zueinander verlaufen und die durch zwei Stege 15 und 16 verbunden sind. Von der oberen Klemmbacke 7 sind nur die Klemmplatte 14 und die Befestigungsplatte 13 sichtbar. Die Befestigungsplatte 13 ist am entsprechenden Schenkel 2 bzw. 3 befestigt, während die beiden Klemmplatten 14 einander zugewandte Klemmflächen zum Festklemmen des Substrates 8 aufweisen. Die Klemmplatte 14 ist über die beiden Stege 15 und 16 gegenüber der Befestigungsplatte 13 in Transportrichtung verschiebbar gelagert. Die Befestigungsplatte 13, die Klemmplatte 14 und die beiden Stege 15 und 16 sind aus einem Stück Material gefertigt und bilden ein Festkörpergelenk. Die beiden Klemmbacken 6 und 7 können identisch ausgebildet sein. Sie können aber auch wie bei dem in der Fig. 3 gezeigten Ausführungsbeispiel eine unterschiedliche Geometrie aufweisen, so dass die Stege 15 und 16 der unteren Klemmbacke 6 in senkrechter Richtung, die Stege 15 und 16 der oberen Klemmbacke 7 hingegen in horizontaler Richtung verlaufen.

Jede auf das eingeklemmte Substrat 8 in oder entgegen der Transportrichtung 12 ausgeübte Kraft bewirkt eine Auslenkung der Klemmplatten 14 gegenüber den an den Schenkeln 2 bzw. 3 des Klemmelementes 1 festgeschraubten Befestigungsplatten 13. Dabei werden die Stege 15 und 16 verbogen. Dieses Verbiegen der Stege 15 und 16 wird mittels eines Sensors erfasst und ausgewertet. Der Sensor besteht vorzugsweise aus vier Dehnmessstreifen 17 - 20, die zu einer Brückenschaltung verdrahtet sind. Die vier Dehnmessstreifen 17 - 20 sind auf die Stege 15 und 16 aufgeklebt, wobei sich in Transportrichtung 12 gesehen je ein Dehnmessstreifen auf jeder Seite des Steges befindet. Die vier Dehnmessstreifen 17 - 20 stellen piezoelektrische Widerstände dar. Das Ausgangssignal $U_{out}$ der Brückenschaltung wird verstärkt und es wird ein Signal U gebildet, das angibt, ob die Klemmbacken 6 und 7 weiterhin geschlossen bleiben oder geöffnet werden sollen. Das Signal U ist ein binäres Signal, das die beiden Zustände "klemmen" und "öffnen" bezeichnet. Die Befestigungsplatte 13, die Klemmplatte 14 und die beiden Stege 15 und 16 bilden zusammen mit den vier Dehnmessstreifen 17 - 20 den Kraftsensor.

Beim Transport des Substrats 8 wirken verschiedene Kräfte auf die Klemmbacken 6 und 7 ein, nämlich durch das Beschleunigen und Abbremsen bewirkte Kräfte, sowie Reibungskräfte, da das Substrat 8 auf einer Unterlage gleitet. Die Summe dieser Kräfte bewirkt eine ständig wechselnde Auslenkung der Klemmplatten 14 gegenüber den an den Schenkeln 2 bzw. 3 des Klemmelementes 1 festgeschraubten Befestigungsplatten 13.

Im folgenden werden zwei Varianten erläutert, wie aus dem Signal Uout das Signal U gebildet werden kann. Das Signal Uout wird bei beiden Varianten an sich bekannten statistischen Methoden unterzogen, um Rauschen und/oder Störsignale zu eliminieren oder mindestens zu dämpfen.

Variante 1

Bei dieser Variante führt das Signal U den Wert "öffnen", sobald das Signal $U_{out}$ einen vorbestimmten Schwellwert $U_s$ überschreitet. Wenn das vom Klemmelement 1 transportierte Substrat 8 irgendwo anstösst, dann werden die Klemmplatten 14 gegenüber den an den Schenkeln 2 bzw. 3 des Klemmelementes 1 festgeschraubten Befestigungsplatten 13 zunehmend weiter ausgelenkt. Sobald die Auslenkung ein dem Schwellwert $U_s$ entsprechendes Mass überschreitet, wird der Befehl zum Öffnen der Klemmbacken 6 und 7 abgegeben.

Variante 2

Bei dieser Variante werden auch Daten über den aktuellen Zustand der Transportbewegung berücksichtigt. Im folgenden bezeichnet die Variable t die Zeit. Die Fig. 4 zeigt das an den zugeordneten Antrieb angelegte Steuersignal $U_{st}(t)$, das dem vorgegebenen Verlauf der Beschleunigung des Klemmelementes 1 in Transportrichtung 12 entspricht, und das vom Sensor gelieferte Signal $U_{out}(t)$. Das Signal $U_{out}(t)$ folgt zeitlich versetzt dem Steuersignal $U_{St}(t)$.

Der Transport des Substrats 8 erfolgt taktweise: Das Klemmelement 1 klemmt das Substrat 8 fest, transportiert es um eine bestimmte Strecke, löst die Klemmung des Substrats 8, und wird um eine bestimmte Distanz zurückbewegt. Dann erfolgt gegebenenfalls der nächste Takt. Für den Transport des Substrats 8 während eines Taktes enthält das Steuersignal $U_{St}(t)$ drei aufeinanderfolgende Phasen: eine Beschleunigungsphase, eine beschleunigungslose Phase und eine Bremsphase. Das Signal $U_{out}(t)$ verschwindet nicht während der beschleunigungslosen Phase, weil eine Reibungskraft auf das auf der Unterlage gleitende oder beim Einfahren ins Magazin an einer Rille oder Seitenwand reibende Substrat 8 einwirkt.

Aus dem Steuersignal U$_{St}$(t) wird nun ein Signal U$_a$(t) gebildet, das annähernd dem im Kraftsensor in Folge der Beschleunigung erzeugten Signal entspricht. Dann wird ein um dieses Signal U$_a$(t) korrigiertes Ausgangssignal U$_{out,korr}$(t) gebildet:

$$U_{Out,\,korr}(t) = U_{Out}(t) - U_a(t)$$

Auch bei dieser Variante führt das Signal U den Wert "öffnen", sobald das korrigierte Ausgangssignal U$_{out,\,korr}$(t) bzw. ein von diesem abgeleitetes Signal einen vorbestimmten Schwellwert U$_S$ überschreitet.

Das Signal U$_a$(t) wird aus dem Steuersignal U$_{St}$(t) beispielsweise gebildet, in dem das Steuersignal U$_{St}$(t) skaliert und zeitlich verzögert wird:

$$U_a(t) = k * U_{St}(t - \Delta t_1)$$

Der Parameter $\Delta t_1$ bezeichnet eine konstante Zeitdauer und der Parameter k eine Konstante, die über eine Eichmessung zu bestimmen ist.

Der Vorteil der zweiten Variante liegt darin, dass bei dieser Art der Auswertung die Auslenkung der Klemmbacken 6 und 7 in Folge der Beschleunigung des Klemmelementes 1 nicht als Hängenbleiben des Substrates 8 interpretiert wird.

Bei beiden Varianten kann das Signal des Sensors U$_{out}$(t) bzw. U$_{out,korr}$ (t) Signalspitzen aufweisen, die durch elektrische Störungen bedingt sind und nicht vom Anstossen oder Hängenbleiben des Substrates herrühren. Bevorzugt werden deshalb in der Signaltechnik übliche Methoden angewendet, um derartige Signalspitzen herauszufiltern, und erst aus dem gefilterten Signal das Signal U gebildet, damit das Signal U nur dann vom Wert "schliessen" auf den Wert "öffnen" wechselt, wenn das transportierte Substrat tatsächlich hängengeblieben ist.

Fakultativ weisen die Klemmbacken 6 und 7 im Beispiel der Fig. 3 je ein von der Befestigungsplatte 13 ausgehendes, starres Teil 21 auf, das eine gegen den Steg 15 gerichtete Fläche 22 und eine gegen den Steg 16 gerichtete Fläche 23 aufweist. (Es ist nur das an der Befestigungsplatte 13 der Klemmbacke 6 befestigte Teil 21 sichtbar, das Teil 21 der Klemmbacke 7 ist nicht sichtbar). Das Teil 21 dient dazu, während des Betriebs eine mechanische Überdehnung der Stege 15 und 16 der Klemmbacken 6 und 7 zu verhindern. Die Fläche 22 und der Steg 15 sind im Ruhezustand durch einen Luftspalt getrennt, ebenso sind die Fläche 23 und der Steg 16 durch einen Luftspalt getrennt. Beim Beschleunigen und Abbremsen des Klemmelementes ändert sich in Folge der Auslenkung der Stege 15 und 16 die Grösse dieser Luftspalte. Die Grösse der Luftspalte im Ruhezustand ist so bemessen, dass entweder der Steg 15 an der Fläche 22 oder der Steg 16 an der Fläche 23 zum Anschlag kommt, bevor der Steg 15 bzw. der Steg 16 plastisch deformiert werden kann.

**Patentansprüche**

1. Klemmelement, das einen ersten und einen zweiten Schenkel (2, 3) mit einer ersten bzw. zweiten Klemmbacke (6; 7) zum Einklemmen eines Substrats (8) aufweist, **dadurch gekennzeichnet, dass** jede der beiden Klemmbacken (6; 7) eine Klemmplatte (14) aufweist, die gegenüber dem entsprechenden Schenkel (2 bzw. 3) in einer vorbestimmten Richtung verschiebbar gelagert ist, und dass ein Sensor vorhanden ist für die Messung der Auslenkung der ersten Klemmplatte (6) gegenüber dem ersten Schenkel (2).

2. Klemmelement nach Anspruch 1, **dadurch gekennzeichnet, dass** die erste Klemmplatte (14) über zwei Stege (15, 16) mit einer ersten Befestigungsplatte (13) verbunden ist, die am ersten Schenkel (2) befestigt ist, und dass die zweite Klemmplatte (14) über zwei Stege (15, 16) mit einer zweiten Befestigungsplatte (13) verbunden ist, die am zweiten Schenkel (3) befestigt ist.

3. Klemmelement nach Anspruch 2, **dadurch gekennzeichnet, dass** der Sensor aus Dehnmessstreifen besteht, die an den Stegen (15, 16) befestigt sind, die die erste Klemmplatte (14) und die erste Befestigungsplatte (13) verbinden.

4. Klemmelement nach einem der Ansprüche 1 bis 3, **dadurch gekennzeichnet, dass** an einem der beiden Schenkel (2) ein Bolzen (9) befestigt ist, der am anderen Schenkel (3) gelagert ist.

**Claims**

1. Clamping element comprising a first and a second leg (2; 3) with a first or second clamping jaw (6; 7) for clamping a substrate (8), **characterised in that** each of the two clamping jaws (6; 7) has a clamping plate (14) which is movable in a predefined direction relative to the corresponding leg (2 or 3) and that a sensor is present for measurement of the deflection of the first clamping plate (6) relative to the first leg (2).

2. Clamping element according to claim 1, **characterised in that** the first clamping plate (14) is connected via two bridges (15, 16) to a first fixing plate (13) which is secured to the first leg (2) and that the second clamping plate (14) is connected via two bridges (15, 16) to a second fixing plate (13) which is secured to the second leg (3).

3. Clamping element according to claim 2, **characterised in that** the sensor consists of strain gauges which are secured to the bridges (15, 16) which connect the first clamping plate (14) and the first fixing plate (13).

4. Clamping element according to one of claims 1 to 3, **characterised in that** a bolt (9) is secured to one of the two legs (2) which bears on the other leg (3).

**Revendications**

1. Elément de serrage présentant une première et une seconde branche (2, 3) munies d'une première ou d'une seconde mâchoire de serrage (6 ; 7) pour coincer une substrat (8), **caractérisé en ce que** chacune des deux mâchoires de serrage (6 ; 7) présente une plaque de serrage (14) qui est montée avec faculté de translation à l'opposé de la branche correspondante (2 ou 3) dans une direction prédéterminée, et **en ce qu'**un capteur est présent pour mesurer la déviation de la première plaque de serrage (6) par rapport à la première branche (2).

2. Elément de serrage selon la revendication 1, **caractérisé en ce que** la première plaque de serrage (14) est reliée par l'intermédiaire de deux barrettes (15, 16) à une première plaque de fixation (13) qui est fixée sur la première branche (2), et **en ce que** la seconde plaque de serrage (14) est reliée par l'intermédiaire de deux barrettes (15, 16) à une seconde plaque de fixation (13) qui est fixée sur la seconde branche (3).

3. Elément de serrage selon la revendication 2, **caractérisé en ce que** le capteur est constitué d'extensomètres à résistance qui sont fixés sur les barrettes (15, 16) qui relient la première plaque de serrage (14) et la première plaque de fixation (13).

4. Elément de serrage selon l'une des revendications 1 à 3, **caractérisé en ce qu'**un boulon (9) est fixé sur une des deux branches (2), ledit boulon étant monté sur l'autre branche (3).

# Fig.1

# Fig.2

# Fig.3

## Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 330831 A
- CH 679878

- US 5388751 A